# EUROPÄISCHE PATENTSCHRIFT

(11) **EP 0 627 021 B1**
(45) Veröffentlichungstag und Bekanntmachung des Hinweises auf die Patenterteilung: **09.10.1996**
(21) Anmeldenummer: 93903816.2
(22) Anmeldetag: 17.02.1993
(51) Int. Cl.: C25D 5/54, H05K 3/42

(54) **VERFAHREN ZUR METALLISIERUNG VON NICHTLEITEROBERFLÄCHEN UND DIE VERWENDUNG VON HYDROXIMETHANSULFINSÄURE IM VERFAHREN**
PROCESS FOR METALLIZING NON-CONDUCTING SURFACES, AND THE USE OF HYDROXYMETHYL SULPHINIC ACID IN THAT PROCESS
PROCEDE DE METALLISATION DE SURFACES NON CONDUCTRICES ET UTILISATIONS D'ACIDE SULFINIQUE DE METHOXY

(30) Priorität: 28.02.1992 DE 4206680
(43) Veröffentlichungstag der Anmeldung: 07.12.1994
(73) Patentinhaber: ATOTECH Deutschland GmbH, 10553 Berlin (DE)
(72) Erfinder: STAMP, Lutz, D-1000 Berlin 27 (DE); ZETTELMEYER-DECKER, Elisabeth, D-1000 Berlin 30 (DE); TIEMANN, Norbert, D-1000 Berlin 19 (DE)
(74) Vertreter: Effert, Udo, Dipl.-Ing.
(86) Internationale Anmeldenummer: DE9300153
(87) Internationale Veröffentlichungsnummer: WO9317153

(56) Entgegenhaltungen:
- EP-A- 0 298 298
- WO-A-91/07526

## Beschreibung

Die Erfindung betrifft ein Verfahren zur Metallisierung von Nichtleiteroberflächen und die Verwendung von Hydroximethansulfinsäure im Verfahren.

Die Verwendung von metallbeschichteten, nichtleitenden Materialien als Leiterplatte ist weit verbreitet. Es wechseln dabei immer Lagen mit Leiterbahnen und Lagen aus nichtleitenden Material miteinander ab. Zum elektrischen Verbinden von Leiterbahnen verschiedener Lagen werden an geeigneten Stellen Bohrungen gesetzt. Diese können das Material vollständig oder auch nur teilweise (sogenannte Sacklöcher) durchdringen. Durch Metallisieren der Bohrungen werden die elektrischen Verbindungen zwischen den verschiedenen Leiterbahnen hergestellt.

Für diesen Zweck sind eine ganze Reihe unterschiedlicher Verfahren bekannt geworden. Angewendet werden zur Zeit noch am häufigsten die Verfahren, die zum Metallisieren des nichtleitenden Basismaterials ein außenstromlos (chemisch) abscheidendes Metallisierungsbad benutzen. Sehr oft ist dies ein Kupferbad, aber auch chemisch abscheidende Nickelbäder werden verwendet. Derartige außenstromlose Metallisierungsbäder haben mehrere schwerwiegende Nachteile: Sie arbeiten mit Chemikalien, die in der Handhabung problematisch sind und deren Entsorgung hohe Kosten verursacht, wie z. B. Formalin und Komplexbildner (EDTA u.a.). Der Überwachungsaufwand für diese Bäder ist erheblich, die Bäder haben nur eine sehr begrenzte Standzeit und einen sehr hohen Chemikalienverbrauch.

Deshalb sind in den letzten Jahren verstärkt Verfahren entwickelt worden, die ohne den Schritt stromlose Metallabscheidung auskommen:
1. Belegen der Bohrlochwandungen mit einer Schicht aus Kohlenstoffpartikeln und anschließende galvanische Metallisierung. Das Verfahren ist unselektiv und belegt leitende und nichtleitende Materialien gleichermaßen. Dadurch entsteht bei der Ankontaktierung zwischen den Leiterbahnen und der Bohrlochhülse eine Trennschicht aus Kohlenstoff. Bei thermischer oder mechanischer Belastung der Leiterplatte kann es dann zu Innenlagenabrissen an diesen Stellen kommen (EP-A 244535).
2. Erzeugen einer leitfähigen Polymerschicht aus der Bohrlochwandung. Dieses Verfahren ist an aufwendige apparative Voraussetzungen gebunden und ist Beschränkungen hinsichtlich der bearbeitbaren Basismaterialien ausgesetzt.
3. Belegen des nichtleitenden Materials mit einer Schicht aus Nichtmetallchalgogenid (in der Regel Sulfid) und anschließend galvanische Metallisierung (US-4952286, US-4919768, US-4810333, EP 298298). Das Verfahren ist ebenfalls unselektiv und belegt auch die Kupferoberflächen mit einer Sulfidschicht, die in einem zusätzlichen Prozeßschritt wieder entfernt werden muß.
4. Behandlung von katalytisch aktivierten Oberflächen vor der galvanischen Metallabscheidung mit stickstoffhaltigen organischen Verbindungen (DE-OS 3741 459).

Es sind weiterhin eine Reihe von Verfahren bekannt geworden, die einen kolloidalen Palladium/Zinn Katalysator benutzen, um auf einer nichtleitenen Oberfläche eine geringe Grundleitfähigkeit zu erzeugen, gerade ausreichend, um direkt darauf galvanisch ein Metall abzuscheiden (EP-A-248683, DE-3323476, DE-3304004, US-3099608, EP-A-398019, DE-3339946). Nachteilig bei diesen Sytemen ist der hohe Gehalt an Säure und Chloriden in dem Pd/Sn Katalysator. Hierdurch wird ein Angriff auf die Oxid-Grenzschicht zwischen Kupfer und Nichtleiter ermöglicht, und die behandelten Leiterplatten sind anfällig für den Rotring Fehler. Um eine fehlerlose Ankontaktierung der Innenlagen zu erhalten, muß zudem das Zinnhydroxyd möglichst vollständig von den Kupfer Innenlagen entfernt werden. Auf dem Harz der Bohrlöcher muß jedoch eine Mindestmenge von Zinn zurückbleiben, da ansonsten eine vollständige Kupferbelegung beim anschließenden Galvanisieren nicht erreicht werden kann. Diese widersprüchlichen Anforderungen führen dazu, daß diese Verfahren für die Produktion hochwertiger Leiterplatten nicht geeignet sind. Der Erfindung liegt die Aufgabe zugrunde, ein Verfahren zum Durchkontaktieren von Leiterplatten ohne ein chemisch-außenstromloses Metallisierungsbad zu entwicklen, das selektitv nur die nichtleitenden Oberflächen mit einer Katalysatorschicht überzieht und gleichzeitig substratunabhängig arbeitet.

Diese Aufgabe wird durch das erfindungsgemäße Verfahren mit den folgenden Verfahrensschritten gelöst:
1. Konditionierung der Bohrlochoberfläche durch einen Chelatkomplexbildner und/oder eine kationische, oberfkächenaktive Substanz.
2. Behandeln der Leiterplatte mit einer kolloidalen, durch ein organisches Polymer stabilisierten sauren Lösung eines Edelmetalls.
3. Aktivieren der katalytischen Schicht durch eine Lösung, die als eine oder mehrere Schwefelverbindungen Sulfinsäure, Sulfite, Bisulfite, Thiosulfate, Hydroxymethylsulfite, Dithionite, Dithionate oder Tetrathionate enthält.
4. Galvanische Metallisierung bis zur gewünschten Schichtstärke. Gemäß Anspruch 1 kann vor und nach Schritt 1 eine Ätzreinigung und vor Schritt 2 eine Behandlung mit einer Vortauchlösung erfolgen.

Vor dem Metallisierungsprozess werden die Materialien einem Reinigungs- und Vorbehandlungsverfahren unterworfen.
Zur Reinigung der Bohrlochoberfläche können alle bekannten sogenannten Desmear und Reinigungsverfahren sowie Kombinationen hiervon eingesetzt werden. Bekannte Desmearverfahren arbeiten mit Schwefelsäure, Chromsäure oder bevorzugt Permanganat. Auch eine Behandlung der Oberfläche in einem Plasma ist möglich. Reinigungsverfahren arbeiten mit alkalischen und/oder sauren Lösungen, die mindestens eine oberflächenaktive Substanz aus der Klasse der anionischen Tenside, nichtionischen Tenside, kationischen Tenside, Ampholyte oder Polyelektrolyte, nichtionischen oder kationischen Polymeren enthalten.

Als Konditionierungsmittel eignen sich die gleichen Substanzen, die auch für Verfahren mit stromlosen Metallisierungsbädern geeignet sind. Hier sind in erster Linie kationische Netzmittel wie Trimethylalkylammoniumhalogenide, kationische Polyelektrolyte wie quarterniertes Polyvinylimidazol oder stickstoffhaltige Chelatkomplexbildner wie Triethanolamin geeignet.

Als Edelmetallkolloid können Kolloide der Metalle Palladium, Platin, Rhodium, Ruthenium, Silber und Gold eingesetzt werden, wobei Palladium ganz besonders bevorzugt ist. Die Konzentration des Metalls in den erfindungsgemäß eingesetzten Bädern kann zwischen 50 mg/l und mehreren Gramm pro Liter betragen, wobei die Wirtschaftlichkeit des Verfahrens die Konzentration nach oben begrenzt. Sehr gute Ergebnisse werden in der Regel mit Konzentrationen zwischen 100 und 500 mg/l erhalten. Die Kolloide werden mit einem ionischen oder nichtionischen, löslichen organischen Polymer stabilisiert. Es eignen sich hierzu Naturstoffe wie zum Beispiel Proteine, Peptide, Polysaccharide, Gelatine, Agar-Agar, Gummi Arabicum, Tannin oder auch synthethische Polymere wie Polyvinylpyridin, Polyvinylalkohol, Polyvinylacetat, Polyethylenglycol, Polyimine, Polyacrylsäure, Polyacrylamid, Polyacrylate, Polivinylpyrrolidon, Polyvinylmethylketon sowie Kopolymere und Mischungen dieser Komponenten. Besonders gut eignet sich Polyvinylpyrrolidon. Das Molekulargewicht der Polymeren kann zwischen 1.000 und 10.000.000 liegen. Das Verhältnis Metall:Polymer kann zwischen 3:1 und 1:100 betragen, bevorzugt ist der Bereich zwischen 1:1 und 1:10.

Die Herstellung derartiger Kolloide ist beschrieben in den EP-A-187962 und EP-A-163831 und DE-PS 37 41 459.

Vorteilhaft ist es sowohl wegen der Kosten als auch wegen der einfacheren Handhabung, wenn das Lösungsmittel für das Kolloid Wasser ist. Technisch möglich ist jedoch auch die Verwendung eines organischen Lösungsmittels oder Mischungen derselben untereinander oder mit Wasser.

Ein Gehalt des Metallkolloids an Chlorid-, Bromid- oder Iodidionen von 0,1 bis 50 g/l erleichtert die anschließende galvanische Metallisierung der Bohrlöcher. Eine gleichmäßige Metallbelegung ist schon nach deutlich kürzeren Galvanisierzeiten zu erreichen.

Erhöhte Temperaturen beim Behandeln der Leiterplatten mit dem Metallkolloid verbessern ebenfalls die Galvanisierbarkeit. Eine Temperatur im Bereich zwischen 50 und 80 °C hat sich als vorteilhafte Ausführungsform erwiesen. Grundsätzlich kann das erfindungsgemäße Verfahren jedoch bei allen Temperaturen zwischen dem Erstarrungs- und dem Siedepunkt des verwendeten Lösungsmittels betrieben werden.

Der pH-Wert des Metallkolloids ist von entscheidendem Einfluß auf die Galvanisierbarkeit der damit behandelten Nichtmetalloberflächen. Beste Ergebnisse erhält man mit pH-Werten im sauren Bereich zwischen 1 und 3, mit einem Optimum bei 1,5 bis 2.

Werden die Kolloide bei sauren pH-Werten eingesetzt, kommt es, insbesondere bei den weniger edlen Edelmetallen wie Silber, Palladium und Ruthenium, zu einer langsamen Oxidation und Wiederauflösung des Metalls durch Luftsauerstoff oder verschlepptes Oxidationsmittel. Das Eintragen von Oxidationsmitteln wird durch Behandeln der Leiterplatten mit einer verdünnten Lösung eines Reduktionsmittels vor der Behandlung mit dem Metallkolloid verhindert. Zusätzlich ist es vorteilhaft, zu dem Metallkolloid regelmäßig geringe Mengen Reduktionsmittel zuzusetzen. Besonders bevorzugt ist eine Ausführungsform, bei der mittels einer Elektrode das Reduktionspotential in der Metallkolloidlösung permanent überwacht wird und durch automatische Nachdosierung von Reduktionsmittel auf einem konstanten Wert gehalten wird. Diese Vorgehensweise hat sich insbesondere auch bei den Reduktionsmitteln (wie z. B. Borwasserstoffverbindungen, Hypophosphit) als vorteilhaft erwiesen, die durch das Edelmetallkolloid katalytisch zersetzt werden. In diese Fall übernimmt der bei der Zersetzung entstehende Wasserstoff die Pufferung gegen Oxidationsmittel.

Die so aufgebrachte katalytische Edelmetallschicht kann in einem weiteren Schritt aktiviert werden. Hierdurch wird die galvanische Metallisierung wesentlich erleichtert. Kennzeichnend für diesen Schritt ist, daß Verbindungen eingesetzt werden, die nur auf die katalytische Edelmetallschicht einwirken und die Kupferoberflächen nicht verändern. Dies wird erreicht durch verdünnte Lösungen von Verbindungen, die Schwefel in einer Oxidationsstufe enthalten, für die gilt: (Ox) 0 < Ox < 6). In diese Klasse fallen die gemäß der Erfindung verwendeten Sulfonsäuren, Sulfinsäuren, Sulfoxide, Sulfone, Sulfite, Dithionite, Dithionate und Tetrathionate. Besonders geeignet sind Sulfinsäuren, insbesondere die Hydroxymethansulfinsäure.

Die so behandelten Leiterplatten können jetzt ohne weitere Behandlung in einem beliebigen galvanischen Metallisierungsbad galvanisiert werden. Wegen der besonders guten Leitfähigkeit dieses Metalls ist ein Kupferüberzug besonders bevorzugt, aber ein Aufbringen anderer Metalle ist, falls gewünscht, ebenfalls möglich. Als besonders vorteilhaft hat sich die Verwendung von Mattkupferbädern erwiesen. Die zu metallisierenden Oberflächen sind hiermit schon nach einer besonders kurzen Zeit vollständig mit einer geschlossenen Metallschicht belegt.

### Beispiel 1: Herstellung des Katalysators

Lösung a: 1,7 g PdCl₂ werden in 40 ml (10-200 ml) 20%iger Salzsäure, gegebenenfalls unter leichtem Erwärmen, gelöst. Anschließend wird mit Wasser auf 1 Liter verdünnt. Zu dieser Lösung wird Polyvinylpyrrolidon K15 zugefügt und nach dem Lösen mit Wasser auf 3 Liter aufgefüllt.

Lösung b: 10 g (5-100 g/l) NaH₂PO₂ . H₂O werden in 11 Wasser gelöst.
Die Lösung b wird unter intensivem Rühren zu der Lösung a hinzugefügt. Nach kurzer Zeit beginnt die Lösung dunkel zu werden und eine Gasentwicklung setzt ein. Die Reaktion ist abgeschlossen, wenn die Gasentwicklung abgeschlossen ist. Nach dem Einstellen des pH mit Salzsäure oder Natronlauge auf 1,8 (0,8 - 3,5) ist die Lösung gebrauchsfertig.

Ein Absetzen der Palladiumpartikel ist auch nach langen Lagerzeiten und bei hohen Temperaturen nicht zu beobachten.
Ist die Lösung längere Zeit intensiv mit Luft in Berührung gekommen, kann es zu einer Rücklösung des Palladiums kommen. In diesem Fall kann der Katalysator durch Zugabe von 2 g/l Natriumhypophosphit regeneriert werden.

### Beispiel 2

Anstelle von Polyvinylpyrrolidon K15 wird Polyvinylpyrrolidon K60 eingesetzt. Es wird ebenfalls ein Katalysator mit guten katalytischen Eigenschaften und hervorragender Stabilität erhalten.

### Beispiel 3: Verfahrensablauf mit Smear Removal

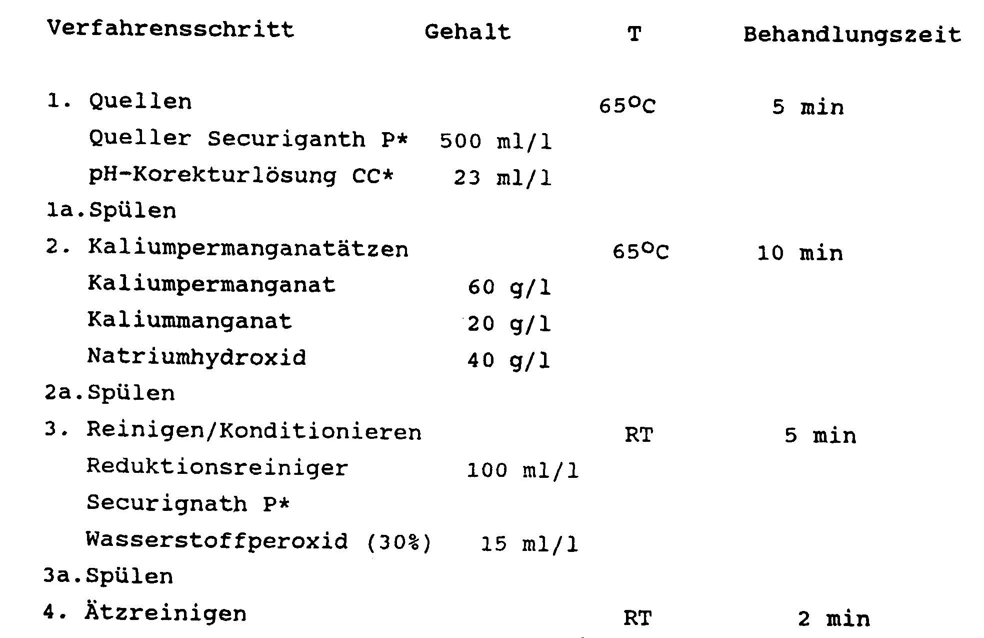

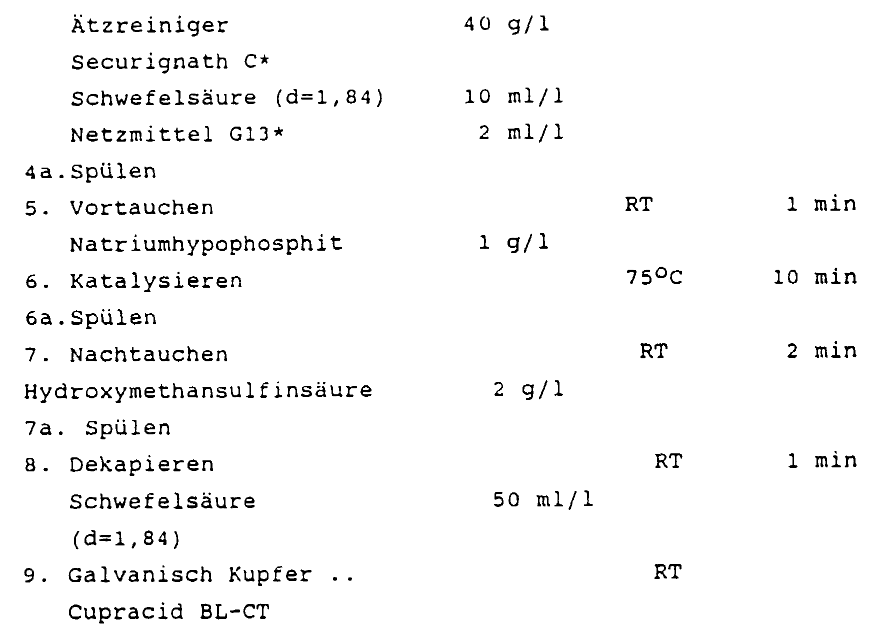

Gemäß diesem Beispiel durchkontaktierte doppelseitige und mehrlagige Leiterplatten aus Epoxidharz mit Papier oder Glasfaser-Verstärkung, Polyimid oder Teflon sind von hervorragender Qualität und zeigen weder Fehler in der Belegung der unterschiedlichen Materialien mit Kupfer noch bei der Ankontaktierung von Innenlagen.

### Beispiel 4: Verfahren entsprechend Beispiel 3 ohne die Schritte 7 und 7a.

So bearbeitete Leiterplatten sind ebenfalls von hoher Qualität. Wird die galvanische Metallabscheidung genau verfolgt, ist jedoch festzustellen, daß eine vollständige Bedeckung der Bohrlochhülsen mit Kupfer länger dauert als im Beispiel 3.

### Beispiel 5: Verfahrensablauf ohne Smear Removal

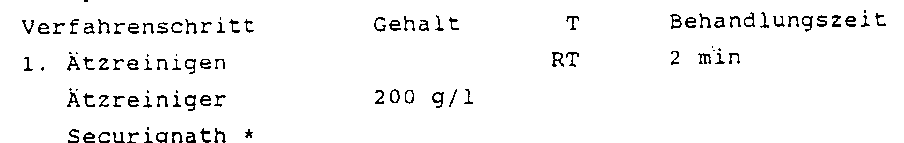

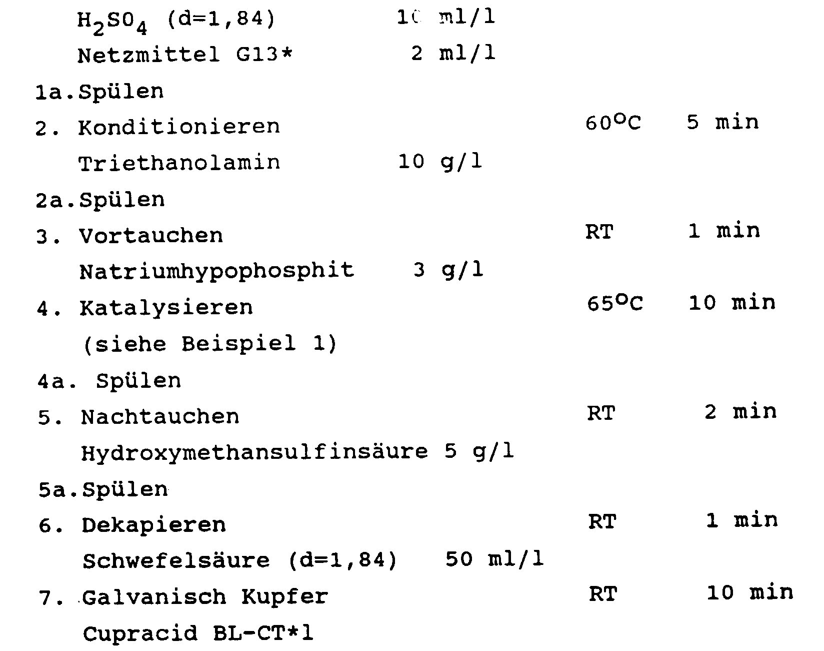

Gemäß diesem Beispiel behandelte flexible, starr-flexible oder starre, doppelseitige und mehrlagige Leiterplatten aus Epoxidharz mit Papier und/oder Glasfaserverstärkung, Polyimid, Thermoplasten oder Keramik sind einwandfrei durchkontaktiert. Während und nach dem Behandeln mit der Nachtauchlösung ist kein Anlaufen der Kupferkaschierung zu beobachten, die Kupferoberflächen sind vielmehr hellrosa gefärbt.

### Beispiel 6:

Verfahren entsprechend Beispiel 5 mit einem Konditionierer aus 5 g/l Natriumcarbonat und 5 g/l Basotronic PVI (Produkt der BASF AG, Ludwigshafen).

Nach diesem Verfahren behandelte Leiterplatten zeigen dieselben guten Ergebnisse wie nach Beispiel 3 bis 5 behandelte.

### Beispiel 7:

Verfahren entsprechend Beispiel 5 oder 6 mit einer Nachtauchlösung aus 10 g/l Natriumthiosulfat anstatt der Hydroxymethansulfinsäure. So behandelte Leiterplatten lassen sich gut galvanisch metallisieren.

### Beispiel 8:

### Verfahrensablauf entsprechend Beispiel 5.

Als Testplatte wird ein 5 cm x 5 cm großes Plättchen aus einseitig kaschiertem FR4 Material eingesetzt. Nach einer galvanischen Verkupferung von 10 min mit 2 Ampere /dm² ist das Plättchen auf der nicht kupferkaschierten Seite von den Kanten her ca. 1 cm mit Kupfer bedeckt.

### Beispiel 9:

Dieses Beispiel dient dem Vergleich des erfindungsgemäßen Verfahrens mit bekannten Verfahren, die auf einem Palladium / Zinn Katalysator beruhen. Hierzu wird ein Verfahren enstprechend Beispiel 8 benutzt. Es wird lediglich im Schritt 4 der Katalysator gegen einen handelsüblichen salzsauren Palladium / Zinn Katalysator (Noviganth Aktivator AK I *, 250 mg/l Palladium , 10 min., 25° C) und im Schritt 5 die Nachtauchlösung gegen eine 2% ige Tetrafluoroborsäurelösung (5 min., RT) ausgetauscht. Das Testplättchen ist nach ebenfalls 10 min bei 2A / dm² an den Kanten nur wenige Millimeter mit Kupfer bedeckt.

### Anmerkungen:

In allen Verfahrensbeispielen handelt es sich um wässrige Lösungen der aufgeführten Inhaltsstoffe. Die angegebenen Konzentrationen der Inhaltsstoffe können oft ohne sichtbare Auswirkungen auf das Ergebnis der Durchkontaktierung um einen Faktor zwei bis fünf über- oder unterschritten werden. Das gleiche gilt für die angegebenen Behandlungszeiten. Temperaturen können häufig um 10 bis 20° C ohne großen Einfluß auf das Ergebnis der Verfahren variiert werden.

## Patentansprüche

1. Verfahren zur Metallisierung von Nichtleiteroberflächen, gekennzeichnet durch die Schritte,
a.) gegebenenfalls Ätzreinigen,
b.) Konditionierung durch einen Chelatbildner und/oder kationische, oberflächenaktive Substanz und/oder kationischen Polyelektrolyten
c.) gegebenenfalls Ätzreinigung,
d.) gegebenenfalls Behandlung mit einer Vortauchlösung,
e.) Behandeln mit einer kolloidalen, durch ein organisches Polymer stabilisierten sauren Lösung eines Edelmetalls,
f.) Behandlung mit einer Lösung, die als eine oder mehrere Schwefelverbindungen Sulfinsäure Sulfite, Bisulfite, Thiosulfate, Dithionite, Dithionate und/oder Tetrathionate enthält,
g.) galvanische Metallisierung.

2. Verfahren gemäß Anspruch 1, wobei die kolloidale saure Lösung des Verfahrensschrittes e) durch Mischen von Säure, Edelmetall und/oder Edelmetallsalz, organischem Schutzkolloid und einem Reduktionsmittel in einem Lösungsmittel hergestellt wird

3. Verfahren gemäß Anspruch 1 oder 2, wobei als Edelmetalle Palladium, Platin, Rhodium, Ruthenium, Silber und Gold eingesetzt werden.

4. Verfahren gemäß Anspruch 1, wobei als organisches Polymer Polyvinylpyridin, Polyvinylalkohol, Polyvinylpyrrolidon, Polyvinylacetat, Polyacrylate oder Kopolymere oder Mischungen eingesetzt werden.

5. Verfahren gemäß Anspruch 1, wobei als Konditionierungsmittel quartärnisiertes Polyvinylimidazol, Triethanolamin oder Monoethanolamin eingesetzt wird.

6. Verwendung von Hydroximethansulfinsäure in einem Verfahren zur Metallisierung von Nichtleiteroberflächen.

## Claims

1. Method of metallising non-conductive surfaces, characterised by the following steps:
a) possible etch-cleaning,
b) conditioning by a chelate former and/or cationic, surface-active substance,
c) possible etch-cleaning,
d) possible treatment with a preliminary immersion solution,
e) treatment with a colloidal acidic solution of a precious metal, which solution is stabilised by an organic polymer,
f) treatment with a solution which contains, as one or more sulphur compounds, sulphinic acid, sulphites, bisulphites, thiosulphates, dithionites, dithionates and/or tetrathionates, and
g) galvanic metallisation.

2. Method according to claim 1, wherein the colloidal acidic solution of method step e) is produced by mixing acid, precious metal and/or precious metal salt, organic protective colloid and a reducing agent in a solvent.

3. Method according to claim 1 or 2, wherein palladium, platinium, rhodium, ruthenium, silver and gold are used as the precious metals.

4. Method according to claim 1, wherein polyvinyl pyridine, polyvinyl alcohol, polyvinyl pyrrolidone, polyvinyl acetate, polyacrylates or copolymers or mixtures are used as the organic polymer.

5. Method according to claim 1, wherein quaternary polyvinyl imidazole, triethanol amine or monoethanol amine is used as the conditioning agent.

6. Use of hydroxymethane sulphinic acid in a method for metallising non-conductive surfaces.

## Revendications

1. Procédé de métallisation de surfaces non conductrices, caractérisé par les étapes de :
a) nettoyage caustique le cas échéant,
b) conditionnement au moyen d'un agent actif de surface de chélation et/ou d'un agent actif de surface cationique et/ou d'un polyélectrolyte cationique,
c) nettoyages caustiques le cas échéant,
d) le cas échéant, traitement par une solution de prétrempage,
e) traitement d'un métal précieux par une solution acide colloïdale stabilisée par un polymère organique,
f) traitement par une solution contenant comme composé(s) soufré(s) simple ou multiples de l'acide sulfinique, des sulfites, des bisulfites, des thiosulfates, des dithionites, des dithionates et/ou des tétrathionates,
g) métallisation galvanique.

2. Procédé selon la revendication 1, dans lequel la solution acide colloïdale de l'étape de procédé e) est préparée en mélangeant l'acide, le métal précieux ou le sel de métal précieux, le colloïde organique protecteur et un agent réducteur dans un solvant.

3. Procédé selon la revendication 1 ou 2, dans lequel les métaux précieux mis en oeuvre sont le palladium, le platine, le rhodium, le ruthénium, l'argent et l'or.

4. Procédé selon la revendication 1, dans lequel sont utilisés comme polymère organique la polyvinylpyridine, l'alcool polyvinylique, la polyvinylpyrrolidone, le polyacétate de vinyle, des polyacrylates ou bien des copolymères ou des mélanges.

5. Procédé selon la revendication 1, dans lequel sont utilisés comme agent de conditionnement le polyvinylimidazole, la triéthanolamine ou la monoéthanolamine quaternarisé(e).

6. Utilisation de l'acide hydroxyméthanesulfinique dans un procédé destiné à la métallisation des surfaces non conductrices.
